# EUROPEAN PATENT APPLICATION

(11) **EP 4 800 417 A1**
(43) Date of publication of application: **02.09.2026**
(21) Application number: 26158214.2
(22) Date of filing: 12.02.2026
(51) Int. Cl.: G01R 33/36

(54) **MAGNETIC RESONANCE IMAGING APPARATUS AND AMPLIFIER APPARATUS**

(30) Priority: 27.02.2025 JP 2025030206
(71) Applicant: Canon Medical Systems Corporation, Tochigi 324- (JP)
(72) Inventor: YAMAKI, Hirofumi, Otawara-shi, 324-0036 (JP); MURAKAMI, Mitsuyuki, Otawara-shi, 324-0036 (JP)
(74) Representative: Marks & Clerk LLP

(57) **Abstract**

A magnetic resonance imaging apparatus according to an embodiment includes a static magnetic field magnet, an amplifier circuit, a phase control circuit, and an RF coil. The static magnetic field magnet is configured to generate a static magnetic field in a bore. The amplifier circuit is configured to amplify an input signal. The phase control circuit is configured to control a phase of a signal amplified by the amplifier circuit on a basis of gain of the amplifier circuit obtained from a signal inputted to the amplifier circuit and a signal amplified by the amplifier circuit, and on a basis of a reference gain. The RF coil is configured to transmit, to a subject placed in the bore, an RF pulse based on a signal amplified by the amplifier circuit and whose phase is controlled by the phase control circuit.

## Description

### FIELD

Embodiments disclosed in the present specification and drawings relate to a magnetic resonance imaging (MRI) apparatus and an amplifier apparatus.

### BACKGROUND

An MRI apparatus excites nuclear spins of a subject placed in a static magnetic field by a radio frequency (RF) pulse at the Larmor frequency, executes a scan that collects magnetic resonance (MR) signals generated from the subject due to the excitation, receives MR signals collected by the scan with an RF coil, and generates MR images based on the MR signals.

Specifically, the subject is excited by applying the RF pulse, which is a radio frequency signal of large power amplified by an amplifier circuit, to the RF coil. Since a load of the amplifier circuit includes not only the RF coil but also the subject, the load varies due to factors other than the RF coil, such as the physique of the subject, an imaging site, a body motion, and a relative positional relationship of the subject with respect to the RF coil. Although impedance matching is normally designed between the amplifier circuit and the RF coil, a mismatch may occur between a characteristic impedance of the amplifier circuit and a load impedance due to load variation.

Conventionally, in order to suppress the influence of such load variation, a large-power isolator is provided between an output end of the amplifier circuit and the RF coil. However, the large-power isolator is physically large in size and expensive. In addition, the large-power isolator has a limitation on its maximum output and affects output characteristics of the amplifier circuit.

### SUMMARY OF THE INVENTION

One of the problems to be solved by the embodiments disclosed in the present specification and the drawings is to suppress variations in transmission efficiency of an amplifier circuit of the MRI apparatus without providing a large-power isolator between an output end of the amplifier circuit and the RF coil. It should be noted, however, that possible problems to be solved by the embodiments disclosed in the present specification and the drawings are not limited to the problem presented above. It is also possible to regard problems corresponding to the advantageous effects achieved by the configurations described in the following embodiments as other problems.

An MRI apparatus according to an embodiment includes a static magnetic field magnet, an amplifier circuit, a phase control circuit, and an RF coil. The static magnetic field magnet is configured to generate a static magnetic field in a bore. The amplifier circuit is configured to amplify an input signal. The phase control circuit is configured to control a phase of a signal amplified by the amplifier circuit on a basis of gain of the amplifier circuit obtained from a signal inputted to the amplifier circuit and a signal amplified by the amplifier circuit, and on a basis of a reference gain. The RF coil is configured to transmit, to a subject placed in the bore, an RF pulse based on a signal amplified by the amplifier circuit and whose phase is controlled by the phase control circuit.

The phase control circuit may determine, on a basis of gain of the amplifier circuit obtained from a signal inputted to the amplifier circuit in a preliminary scan executed before a main scan for obtaining a diagnostic image of the subject and a signal amplified by the amplifier circuit in the preliminary scan, and on the basis of the reference gain, a phase to be used in the main scan, and control, on a basis of a phase determined by the preliminary scan, a phase of a signal amplified by the amplifier circuit in the main scan.

The phase control circuit may determine, as a phase to be used in the main scan, a phase such that a difference between gain of the amplifier circuit obtained in the preliminary scan and the reference gain becomes the same as or smaller than a predetermined amount.

The phase control circuit may control, when the difference is greater than the predetermined amount in the preliminary scan, from a first phase which is phase of the signal amplified by the amplifier circuit to a second phase different from the first phase, and determine, when the difference is the same as or smaller than the predetermined amount in the preliminary scan, the phase of the signal amplified by the amplifier circuit is the second phase , wherein the second phase is as a phase to be used in the main scan.

The phase control circuit may calculate, in the preliminary scan, gain of the amplifier circuit corresponding to each of a plurality of phases as phases of a signal amplified by the amplifier circuit, and determine, on a basis of gain of the amplifier circuit corresponding to each of the plurality of phases, a phase to be used in the main scan.

The magnetic resonance imaging apparatus may further include a current detection circuit that detects current supplied to the amplifier circuit. Wherein, the phase control circuit may determine, when there are a plurality of phases corresponding to gain such that the difference becomes smaller than the predetermined amount, from among the plurality of phases, one phase such that the current becomes smallest, as a phase to be used in the main scan.

The phase control circuit may have a capacitor and adjust a phase of a signal amplified by the amplifier circuit by changing a capacitance of the capacitor.

An amplifier apparatus according to an embodiment connected to an RF coil that transmits an RF pulse to a subject to be imaged by a magnetic resonance imaging apparatus. The amplifier apparatus includes an amplifier, a phase control circuit, and an output part. The amplifier circuit is configured to amplify an input signal. The phase control circuit is configured to control a phase of a signal amplified by the amplifier circuit on a basis of gain of the amplifier circuit obtained from a signal inputted to the amplifier circuit and a signal amplified by the amplifier circuit, and on a basis of a reference gain. The output part is configured to output, to the RF coil, a signal amplified by the amplifier circuit and whose phase is adjusted by the phase control circuit.

The phase control circuit may determine, on a basis of gain of the amplifier circuit obtained from a signal inputted to the amplifier circuit in a preliminary scan executed before a main scan for obtaining a diagnostic image of the subject and a signal amplified by the amplifier circuit in the preliminary scan, and on the basis of the reference gain, a phase to be used in the main scan, and control, on a basis of a phase determined by the preliminary scan, a phase of a signal amplified by the amplifier circuit in the main scan.

The phase control circuit may determine, as a phase to be used in the main scan, a phase such that a difference between gain of the amplifier circuit obtained in the preliminary scan and the reference gain becomes the same as or smaller than a predetermined amount.

The phase control circuit may control, when the difference is greater than the predetermined amount in the preliminary scan, from a first phase, which is a phase of the signal amplified by the amplifier circuit to a second phase different from the first phase, and determine, when the difference is the same as or smaller than the predetermined amount in the preliminary scan, the phase of the signal amplified by the amplifier circuit is the second phase , wherein the second phase is as a phase to be used in the main scan.

The phase control circuit may calculate, in the preliminary scan, gain of the amplifier circuit corresponding to each of a plurality of phases as phases of a signal amplified by the amplifier circuit, and determine, on a basis of gain of the amplifier circuit corresponding to each of the plurality of phases, a phase to be used in the main scan.

The amplifier apparatus may further include a current detection circuit that detects current supplied to the amplifier circuit. Wherein, the phase control circuit may determine, when there are a plurality of phases corresponding to gain such that the difference becomes smaller than the predetermined amount, from among the plurality of phases, one phase such that the current becomes smallest, as a phase to be used in the main scan.

The phase control circuit may have a capacitor and adjust a phase of a signal amplified by the amplifier circuit by changing a capacitance of the capacitor.

### BRIEF DESCRIPTION OF THE DRAWINGS

Fig. 1 is a block diagram illustrating an overall configuration example of an MRI apparatus according to an embodiment.
Fig. 2 is a block diagram illustrating a configuration example of an amplifier apparatus according to a first embodiment.
Fig. 3A is an equivalent circuit diagram illustrating an example of a hybrid-coupling-type phase shifter according to an embodiment.
Fig. 3B is an equivalent circuit diagram illustrating an example of a loaded-line-type phase shifter according to an embodiment.
Fig. 4A is an equivalent circuit diagram illustrating another example of the hybrid-coupling-type phase shifter according to an embodiment.
Fig. 4B is an equivalent circuit diagram illustrating another example of the loaded-line-type phase shifter according to an embodiment.
Fig. 5 is a flowchart illustrating an operation example of the amplifier apparatus according to the first embodiment.
Fig. 6 is a graph illustrating a relationship between input power and gain at the time of a load mismatch.
Fig. 7 is a graph illustrating a relationship between a phase angle for 360° at a particular input power and gain.
Fig. 8 is a flowchart illustrating an operation example of an amplifier apparatus according to a first modification of the first embodiment.
Fig. 9 is a flowchart illustrating an operation example of an amplifier apparatus according to a second modification of the first embodiment.
Fig. 10 is a block diagram illustrating a configuration example of an amplifier apparatus according to a second embodiment.
Fig. 11 is a flowchart illustrating an operation example of the amplifier apparatus according to the second embodiment.
Fig. 12 is a graph illustrating a relationship between input power and current supplied to the amplifier circuit at the time of a load mismatch.
Fig. 13 is a graph illustrating a relationship between a phase angle for 360° at a particular input power and current supplied to an amplifier circuit.

### DETAILED DESCRIPTION

The following will describe an MRI apparatus and an amplifier apparatus according to embodiments, with reference to the accompanying drawings. In the drawings, some of the elements that are the same as each other will be referred to by using the same reference characters, and duplicate descriptions thereof will be omitted.

### (An overall configuration of an MRI apparatus)

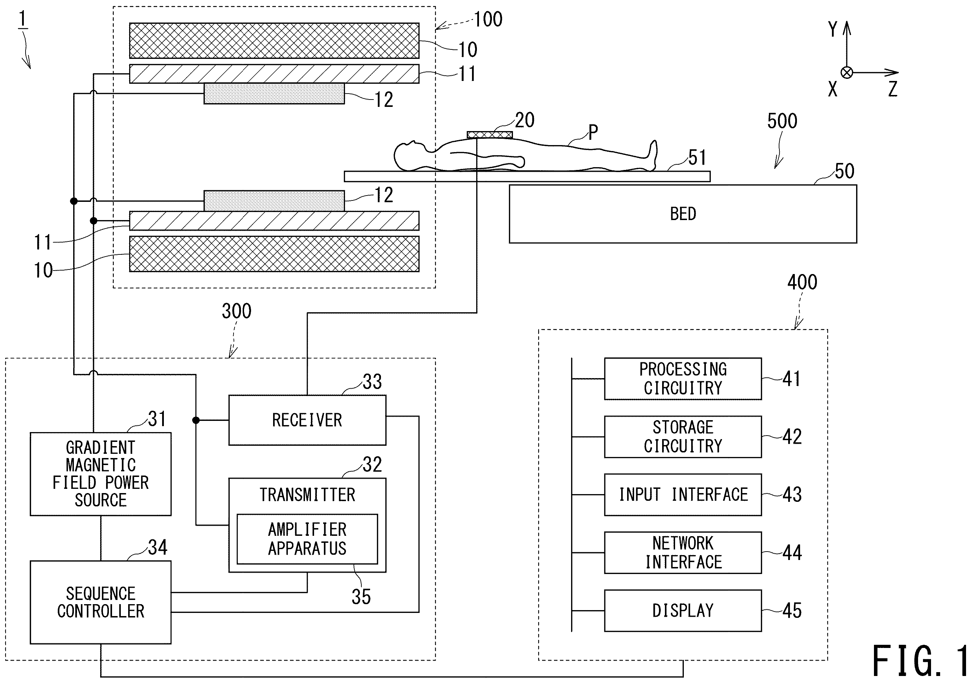

Fig. 1 is a block diagram showing an overall configuration example of an MRI apparatus 1 according to an embodiment. The MRI apparatus 1 includes a gantry apparatus 100, a control cabinet 300, a console 400, and a table 500.

The gantry apparatus 100 includes a static magnetic field magnet 10, a gradient magnetic field coil 11, and a Whole Body (WB) coil 12. These constituent elements are housed in a circular cylindrical casing. The static magnetic field magnet 10 may be an open type in which a pair of magnets are arranged above and below the examination space.

The static magnetic field magnet 10 has a substantially circular cylindrical shape and generates a static magnetic field in a bore the inside of which a patient being an subject is carried into. The bore denotes an examination space inside the circular cylinder of the static magnetic field magnet 10. The static magnetic field magnet 10 has a superconductive coil built therein, and the superconductive coil is cooled, for example by liquid helium, to an extremely low temperature. The static magnetic field magnet 10 generates a static magnetic field by applying, to the superconductive coil, a current supplied from a static magnetic field power source (not shown) in a magnetic excitation mode. After that, when the static magnetic field magnet 10 has transitioned into a permanent current mode, the static magnetic field power source is separated. Having once transitioned into the permanent current mode, the static magnetic field magnet 10 keeps generating a large static magnetic field for a long period of time, such as one year or longer, for example. The static magnetic field magnet 10 may be configured by using a permanent magnet.

The gradient magnetic field coil 11 has a substantially circular cylindrical shape and is fixed to the inside of the static magnetic field magnet 10 in the radial direction of the circular cylindrical shape. The gradient magnetic field coil 11 generates a gradient magnetic field by receiving a supply of a current from a gradient magnetic field power source 31. The gradient magnetic field coil 11 is formed by combining coils corresponding to axes orthogonal to one another, namely, an X axis, a Y axis, and a Z axis. By individually receiving the supply of the current from the gradient magnetic field power source 31, the coils generate the gradient magnetic field of which magnetic field intensities change along the axes, namely, the X axis, the Y axis, and the Z axis.

Here, the Z-axis direction is a direction set along the magnetic flux of the static magnetic field generated by the static magnetic field magnet 10, and is the same direction as the longitudinal direction of the tabletop 51. The Y-axis direction is a vertical direction perpendicular to the Z-axis direction, and is a direction perpendicular to the tabletop 51. The X-axis direction is a direction perpendicular to both the Z-axis and the Y-axis, and is the same direction as the short-side direction of the tabletop 51. The X axis, the Y axis, and the Z axis are orthogonal to one another.

The WB coil 12 is an RF coil that has a substantially circular cylindrical shape and is fixed to the inside of the gradient magnetic field coil 11 so as to surround the subject. The WB coil 12 transmits, to the subject, an RF pulse transferred thereto from a transmitter 32 and receives an MR signal emitted from the subject P in response to excitation of a hydrogen atomic nucleus.

The MRI apparatus 1 may have a local coil 20 in addition to the WB coil 12. The local coil 20 is an RF coil disposed in proximity to the subject and receives an MR signal emitted from the subject in a position close to the subject. The local coil 20 may transmit an RF pulse transmitted from the transmitter 32 to the subject. There are various types of local coils 20 corresponding to imaging sites of the subject, such as the head, the chest, (e.g., Fig. 1), the spine, a leg, and the whole body.

The control cabinet 300 includes the gradient magnetic field power source 31, the transmitter 32, a receiver 33, and a sequence controller 34.

The gradient magnetic field power source 31 causes the gradient magnetic field coil 11 to generate the gradient magnetic field formed along the axes, namely, the X axis, the Y axis, and the Z axis, by supplying the current thereto, under control of the sequence controller 34.

The transmitter 32 is provided with an amplifier apparatus 35. The transmitter 32 generates an RF pulse in the Larmor-frequency band as an RF transmission wave on the basis of an instruction signal from the sequence controller 34, and, after the RF transmission wave is amplified by the amplifier apparatus 35, outputs the RF transmission wave to the RF coil to excite the subject P. The RF coil to which the RF transmission wave is outputted may be the WB coil 12 or may be the local coil 20. Details of the amplifier apparatus 35 will be described later.

The receiver 33 performs an Analog-Digital (AD: Analog-to-Digital) conversion the MR signal received by the RF coil and outputs the converted result to the sequence controller 34. The digitalized MR signal will be referred to as raw data.

Under control of the console 400, the sequence controller 34 executes a scan of the subject P, by driving the gradient magnetic field power source 31, the transmitter 32, and the receiver 33. The sequence controller 34 receives the raw data via the receiver 33 and transmits the received raw data to the console 400.

The sequence controller 34 is provided with processing circuitry (not shown). The processing circuitry of the sequence controller 34 is configured, for example, with a processor that executes a predetermined program or hardware such as a Field Programmable Gate Array (FPGA) or an Application Specific Integrated Circuit (ASIC).

The table 500 includes a bed 50 and a tabletop 51. The bed 50 is capable of moving the tabletop 51 in up- and-down directions and horizontal directions. The subject P placed on the tabletop 51 is moved to a prescribed height and is further moved into the bore.

The console 400 includes processing circuitry 41, storage circuitry 42, an input interface 43, a network interface 44, and a display 45. The console 400 is an image processing apparatus configured by a computer.

The processing circuitry 41 controls the entire MRI apparatus 1. The processing circuitry 41 is a processor that realizes various functions by reading and executing various processing programs that are stored in the storage circuitry 42 or directly incorporated in the processing circuitry 41.

The storage circuitry 42 is a processor-readable recording medium such as a semiconductor memory element, a random access memory (RAM), a flash memory, a hard disk, an optical disk device, for example. The storage circuitry 42 may also be a portable medium such as a universal serial bus (USB) memory or a digital versatile disk (DVD). The storage circuitry 42 stores therein various types of information and data and stores therein various types of programs to be executed by the processor included in the processing circuitry 41.

The input interface 43 includes: various types of input devices used by a user such as a medical technologist for inputting various types of information and data; and input circuitry that processes signals received from the input devices. The input devices may be, for example, a trackball, a switch, a mouse, a keyboard, a touchpad that performs input operations by touching the scanning surface, a touchscreen that combines a display screen and a touchpad, a non-contact input device that uses an optical sensor, and a voice input device. When any of the input devices is operated, the input circuitry generates an instruction signal corresponding to the operation and outputs the generated instruction signal to the processing circuitry 41.

The network interface 44 implements various information communication protocols according to the type of network. The network interface 44 controls communication according to the various protocols, communicates with various types of apparatuses connected to the network in a wired or wireless manner, so as to exchange various type of information and data.

The display 45 is a display device such as a liquid crystal display panel, a plasma display panel, or an organic Electroluminescence (EL) panel. The display 45 displays various types of information and data under the control of the processing circuitry 41. The display 45 may be a Graphical User Interface (GUI) that displays various types of information and data and also functions as an input device.

By employing these constituent elements, the console 400 controls the entirety of the MRI apparatus 1. More specifically, the processing circuitry 41 receives an instruction related to imaging conditions, through an operation performed by the user via the input interface 43. After that, the processing circuitry 41 causes the sequence controller 34 to execute the scan based on the input imaging conditions. Further, the processing circuitry 41 reconstructs an MR image based on the raw data transmitted thereto from the sequence controller 34. The reconstructed MR image is displayed on the display 45 and saved in the storage circuitry 42.

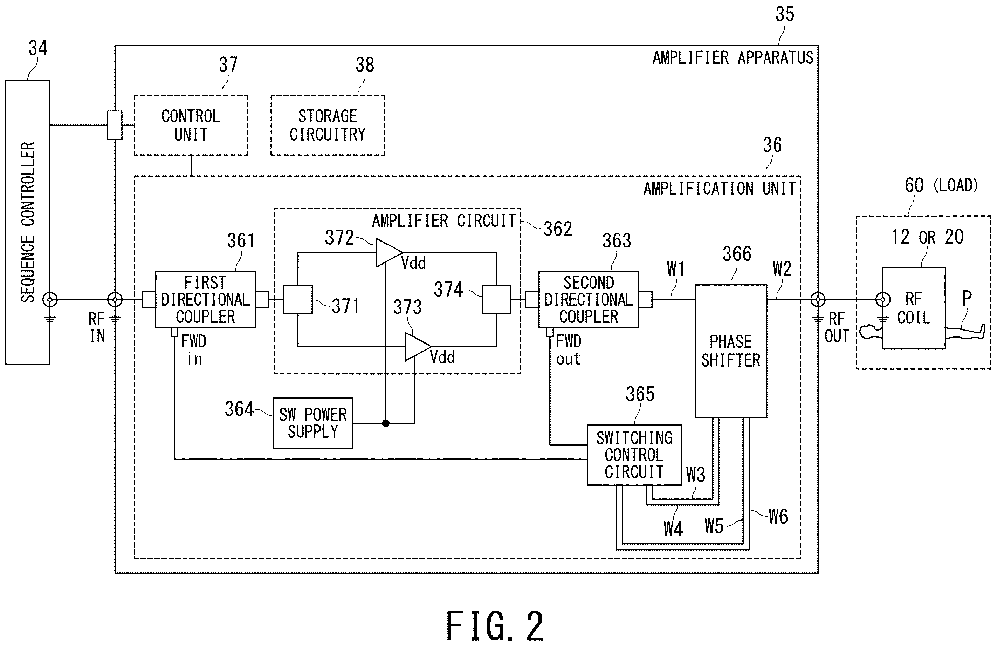

Here, the amplifier apparatus 35 amplifies a high-frequency input signal and applies the amplified high-frequency input signal to the load 60 (see Fig. 2) including the RF coil and the subject P placed in the bore of the MRI apparatus 1. Since the load varies due to factors other than the RF coil, such as the physique of the subject, an imaging site, a body motion, and a relative positional relationship of the subject with respect to the RF coil, a mismatch occurs between a characteristic impedance of an amplifier circuit and a load impedance. As a result, even when the same power is inputted to the amplifier apparatus, a phenomenon occurs in which power that the amplifier apparatus can output varies depending on a state of the load.

Accordingly, the amplifier apparatus 35 according to an embodiment adjusts a phase amount (i.e., a phase shift amount) of a phase shifter 366 such that gain varying due to a load mismatch of an amplifier circuit 362 becomes close to gain of a standard load. That is, a load phase as viewed from the amplifier apparatus 35 is adjusted, and this makes it possible to use the amplifier apparatus 35 in a state where the transmission efficiency is higher.

### (First Embodiment)

Fig. 2 is a block diagram illustrating a configuration example of the amplifier apparatus 35 according to the first embodiment. The amplifier apparatus 35 is provided with an amplification unit 36, a control unit 37, and storage circuitry 38.

The storage circuitry 38 is a recording medium readable by a processor and stores various kinds of information and data. The storage circuitry 38 also stores a reference gain when the amplifier apparatus 35 is connected to a standard load. The standard load is, for example, 50 Ω.

The control unit 37 is configured with various electronic circuits, processors, and the like, and integrally controls the amplification unit 36. The control unit 37 also acquires information about a scan from the sequence controller 34. The information about the scan includes information of an instruction for starting a main scan for acquiring a diagnostic image and information of an instruction for starting a preliminary scan, for example, a calibration scan, before the main scan. A part or all of the control unit 37 and the storage circuitry 38 may be implemented by the sequence controller 34 or a console apparatus 400.

The amplification unit 36 receives an RF pulse (that is, a high-frequency signal) generated on the basis of an instruction signal from the sequence controller 34. The high-frequency signal is inputted to the amplification unit 36 from the sequence controller 34 as analog data or digital data. The amplification unit 36 outputs the amplified high-frequency signal to the RF coil from an output part (for example, see RFOUT in Fig. 2).

The amplification unit 36 is provided with a first directional coupler 361, an amplifier circuit 362, a second directional coupler 363, a switching (SW) power supply 364, a switching control circuit 365, and a phase shifter 366. The switching control circuit 365 and the phase shifter 366 are collectively referred to as a phase control circuit.

The first directional coupler 361 is provided at an input end of the amplifier circuit 362. The first directional coupler 361 detects a high-frequency input signal.

The amplifier circuit 362 amplifies the high-frequency input signal and outputs an output signal. The amplifier circuit 362 is provided with a distributor 371, amplification elements 372 and 373, and a combiner 374. The distributor 371 distributes the high-frequency input signal. The amplification elements 372 and 373 are configured, for example, with FETs, and amplify the input signal in a state where a drain voltage Vdd is applied to the amplification elements 372 and 373. The combiner 374 combines signals amplified by the amplification elements 372 and 373 and outputs the combined signal as the output signal. The number of the amplification elements 372 and 373 and the number of the amplifier circuits 362 are not limited and may be one or a plurality.

The switching (SW) power supply 364 applies the drain voltage Vdd to the amplification elements 372 and 373 on the basis of an instruction signal from the control unit 37.

The second directional coupler 363 is provided at an output end of the amplifier circuit 362. The second directional coupler 363 detects an output signal amplified by the amplifier circuit 362.

The switching control circuit 365 is configured with various electronic circuits, processors, and the like. The switching control circuit 365 calculates gain of the amplifier circuit 362 when the amplifier apparatus 35 is connected to the load 60, on the basis of the input signal detected by the first directional coupler 361 and the output signal detected by the second directional coupler 363. The switching control circuit 365 compares the gain of the amplifier circuit 362 when the amplifier apparatus 35 is connected to the load 60, with the reference gain when the amplifier apparatus 35 is connected to the standard load.

The phase control circuit controls a phase of a signal amplified by the amplifier circuit 362, on the basis of the gain of the amplifier circuit 362 obtained from a signal inputted to the amplifier circuit 362 and a signal amplified by the amplifier circuit 362, and on the basis of the reference gain. Specifically, the switching control circuit 365 adjusts a phase amount of the phase shifter 366 such that the gain of the amplifier circuit 362 when the amplifier apparatus 35 is connected to the load 60 falls within a predetermined range with respect to the reference gain when the amplifier apparatus 35 is connected to the standard load. The phase amount within the predetermined range is a phase such that a difference between the gain of the amplifier circuit 362 and the reference gain becomes the same as or smaller than a predetermined amount. The switching control circuit 365 may switch whether to adjust the phase shifter 366 on the basis of an instruction signal from the sequence controller 34 or the control unit 37.

The phase shifter 366 is provided between the amplifier circuit 362 and the load 60 and is configured to be capable of adjusting a phase amount of an output signal amplified by the amplifier circuit 362. The phase shifter 366 is configured by including at least a capacitor. The capacitor includes, for example, a variable-capacitance capacitor or a variable-capacitance diode (varicap). In this case, the switching control circuit 365 adjusts a phase amount of the phase shifter 366 by changing a capacitance of the capacitor of the phase shifter.

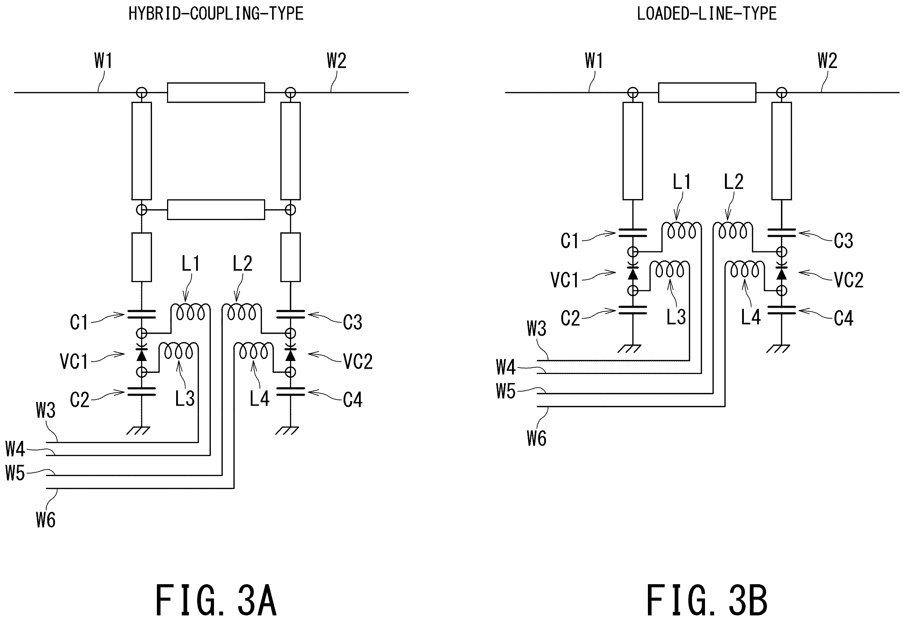

The phase shifter 366 may be a hybrid-coupling-type phase shifter or a loaded-line-type phase shifter. Figs. 3A and 3B are equivalent circuit diagrams illustrating an example of a hybrid-coupling-type phase shifter (Fig. 3A) configured with a distributed-constant circuit and an example of a loaded-line-type phase shifter (Fig. 3B) configured with a distributed-constant circuit. The phase shifter 366 may be configured by including a distributed-constant circuit and a variable-capacitance capacitor or a variable-capacitance diode connected to the distributed-constant circuit.

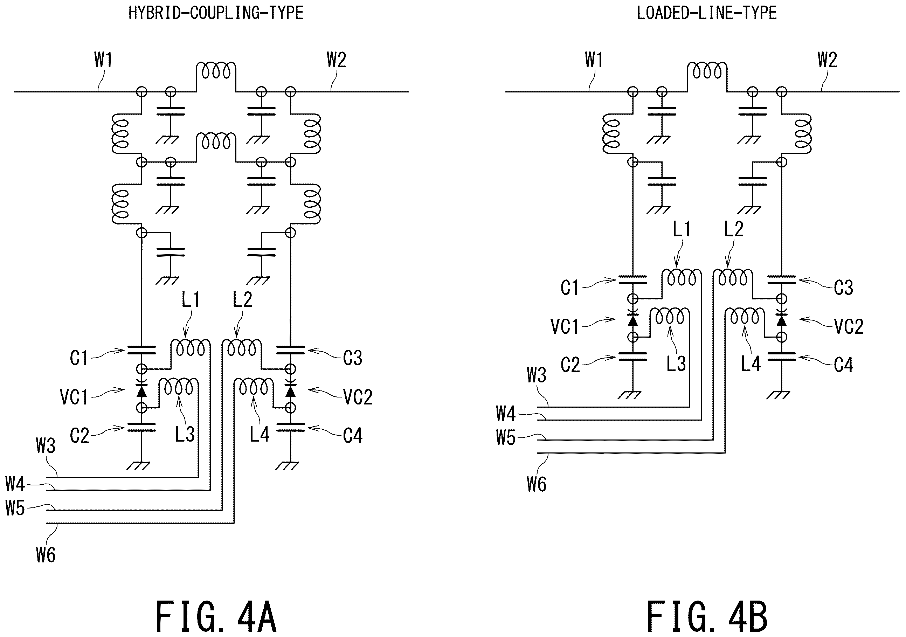

Figs. 4A and 4B are equivalent circuit diagrams illustrating an example of a hybrid-coupling-type phase shifter (Fig. 4A) configured with a lumped-constant circuit and an example of a loaded-line-type phase shifter (Fig. 4B) configured with a lumped-constant circuit. The phase shifter 366 may be configured by including a lumped-constant circuit and a variable-capacitance capacitor or a variable-capacitance diode connected to the lumped-constant circuit.

The phase shifter 366 is connected to the switching control circuit 365 on a route W1 side and to the RF coil on a route W2 side, and is also connected to the switching control circuit 365 on route W3, W4, W5, and W6 sides. The switching control circuit 365 adjusts a phase amount of the phase shifter 366 through the routes W3, W4, W5, and W6.

In Figs. 3A to 4B, the phase shifter 366 is provided with, for example, inductors L1, L2, L3, and L4, capacitors C1, C2, C3, and C4, and variable-capacitance diodes VC1 and VC2. A varicap diode may be used as the variable-capacitance diodes VC1 and VC2. The capacitors C1, C2, C3, and C4 disposed at both ends of the variable-capacitance diodes VC1 and VC2 are preferably capacitors with a higher withstand voltage to comply with larger power outputted by the amplifier circuit 362.

The switching control circuit 365 adjusts a phase amount of the phase shifter 366 by changing a capacitance of the variable-capacitance diodes VC1 and VC2 of the phase shifter. The switching control circuit 365 may adjust a phase amount of the phase shifter 366 by changing a capacitance of the variable-capacitance capacitor of the phase shifter. The phase shifter 366 may be configured with a coaxial cable and a printed board.

In this way, the amplification unit 36 transmits the RF pulse based on the signal amplified by the amplifier circuit 362 and whose phase is controlled by the phase control circuit, to the subject placed in the bore.

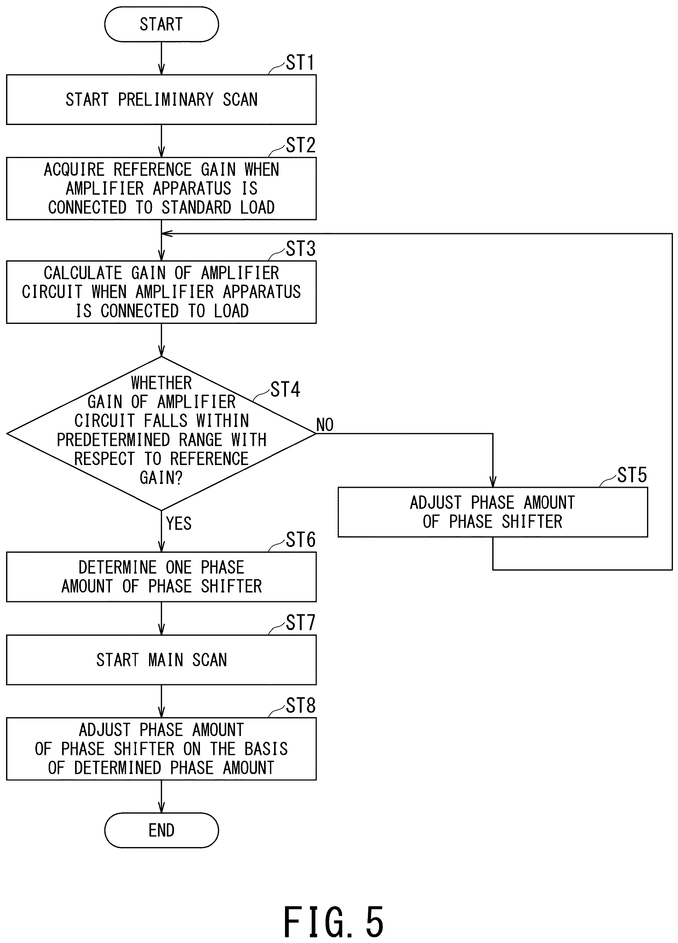

Fig. 5 is a flowchart illustrating an operation example of the amplifier apparatus 35 according to the first embodiment.

In step ST1, the sequence controller 34 outputs an instruction signal for starting a preliminary scan. Before the preliminary scan is started, the amplifier apparatus 35 is connected to the load 60.

In step ST2, the switching control circuit 365 acquires, from the storage circuitry 38, the reference gain when the amplifier apparatus 35 is connected to the standard load.

In step ST3, the switching control circuit 365 calculates the gain of the amplifier circuit 362 when the amplifier apparatus 35 is connected to the load 60. Specifically, the gain of the amplifier circuit 362 is calculated on the basis of the input signal of the amplifier circuit 362 detected by the first directional coupler 361 and the output signal of the amplifier circuit 362 detected by the second directional coupler 363.

In step ST4, the switching control circuit 365 determines whether the gain of the amplifier circuit 362 falls within the predetermined range with respect to the reference gain. Note that the gain of the amplifier circuit 362 falling within the predetermined range with respect to the reference gain includes a case where the gain of the amplifier circuit 362 matches the reference gain. In step ST4, when the gain of the amplifier circuit 362 does not fall within the predetermined range with respect to the reference gain (that is, NO), the process proceeds to step ST5.

In step ST5, the switching control circuit 365 adjusts a phase amount of the phase shifter 366. The phase shifter 366 has, for example, a variable-capacitance circuit such as a varicap diode, and the switching control circuit 365 dynamically changes a capacitance of the variable-capacitance circuit. After a phase amount of the phase shifter 366 is adjusted in step ST5, the process proceeds to step ST3, and the switching control circuit 365 calculates the gain of the amplifier circuit 362 at the phase amount.

When, in step ST4, the gain of the amplifier circuit 362 falls within the predetermined range with respect to the reference gain (that is, YES), the process proceeds to step ST6. In step ST6, the switching control circuit 365 determines one phase amount to be used as a phase amount of the phase shifter 366 in the main scan. Note that, when there are a plurality of phase amounts of the phase shifter 366 corresponding to the gain falling within the predetermined range, the switching control circuit 365 may determine one phase amount from among the plurality of phase amounts. The switching control circuit 365 also determines a phase amount of the phase shifter 366 in the preliminary scan executed before the main scan for obtaining a diagnostic image of the subject P. The determined one phase amount may be stored in the storage circuitry 38.

In step ST7, the sequence controller 34 or the control unit 37 outputs an instruction signal for starting the main scan. Note that the preliminary scan of steps ST1 to ST6 only needs to be executed before the main scan is started, and one main scan may be executed after one preliminary scan, or a plurality of main scans may be executed after one preliminary scan.

In step ST8, the switching control circuit 365 adjusts a phase amount of the phase shifter 366 on the basis of the one phase amount determined in the preliminary scan.

In this way, the phase control circuit determines, on the basis of the gain of the amplifier circuit 362 obtained from the signal inputted to the amplifier circuit 362 in the preliminary scan executed before the main scan and the signal amplified by the amplifier circuit 362 in the preliminary scan, and on the basis of the reference gain, a phase to be used in the main scan, and, on the basis of the determined phase, controls a phase of a signal amplified by the amplifier circuit 362 in the main scan.

Specifically, as shown in steps ST4 to ST6 in Fig. 5, the phase control circuit may control, when a difference between the gain of the amplifier circuit 362 and the reference gain is greater than a predetermined amount in the preliminary scan (that is, NO in step ST4), from a first phase which is a phase of the signal amplified by the amplifier circuit 362 to a second phase different from the first phase, and determine, when the difference between the gain of the amplifier circuit 362 and the reference gain is the same as or smaller than the predetermined amount in the preliminary scan (that is, YES in step ST4), the phase of the signal amplified by the amplifier circuit 362 is the second phase, wherein the second phase is as a phase to be used in the main scan.

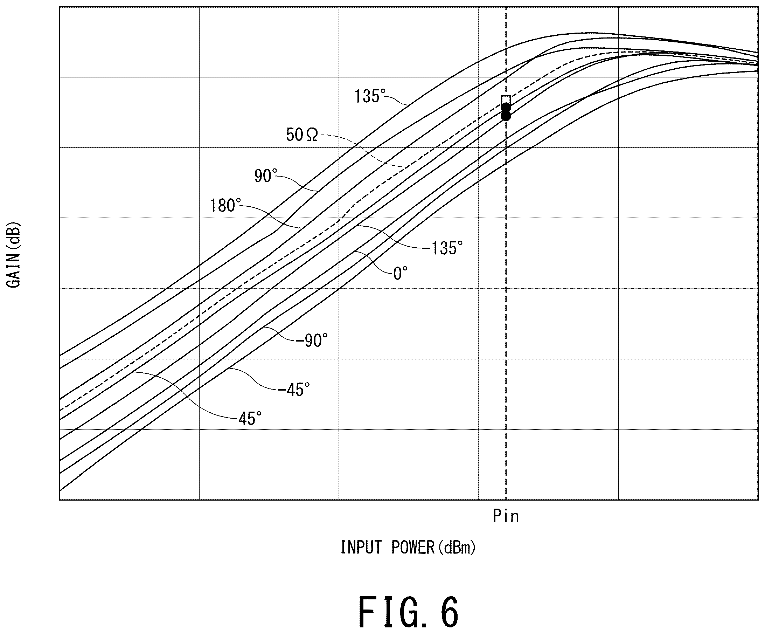

Here, Fig. 6 is a graph illustrating a relationship between input power and gain at the time of a load mismatch. Fig. 6 represents a 50 Ω standard load and a state in which a voltage standing wave ratio (VSWR) has phase angles for 360° in 45° increments from -180° to +180°. In this way, when a load mismatch occurs in the amplifier circuit 362, a phenomenon occurs in which the gain changes even when the same power is inputted.

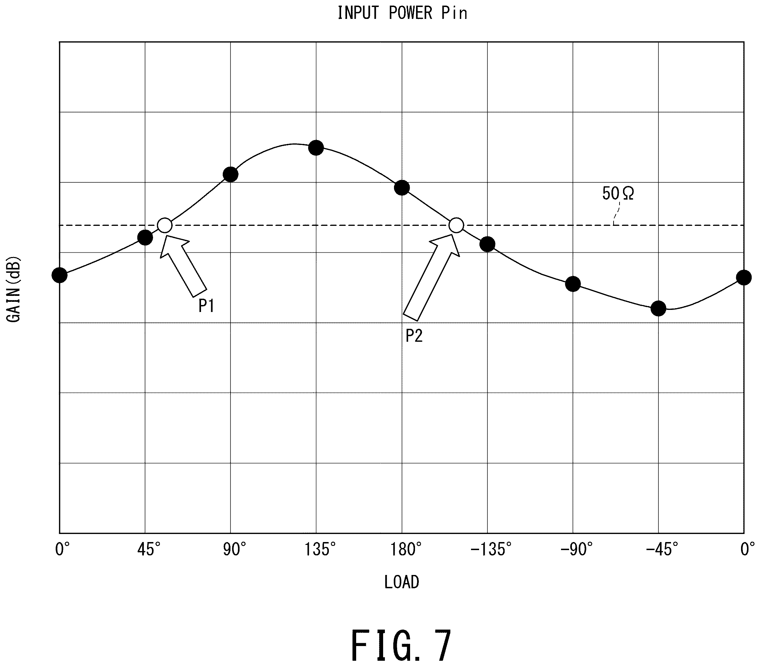

Fig. 7 is a graph illustrating a relationship between a phase angle for 360° at particular input power Pin and gain. In Fig. 7, gain corresponding to a phase angle of 45° and gain corresponding to a phase angle of - 135° are close to the reference gain at the time of the standard load (the gain of a straight line indicated by the broken line in Fig. 7). Note that a phase angle corresponding to gain becoming close to the reference gain is not limited to the phase angles exemplified in Fig. 7 (for example, 45° and -135°).

In the amplifier apparatus 35 according to the embodiment, the phase shifter 366 is adjusted with a phase amount corresponding to a phase angle such that gain close to the reference gain at the time of the standard load is obtained. That is, by adjusting a phase amount of the phase shifter 366, a load phase as viewed from the amplifier circuit 362 is adjusted, variations in transmission efficiency of the amplifier circuit 362 can be suppressed, and gain close to the reference gain at the time of the standard load can be obtained. According to the amplifier apparatus of the first embodiment, without providing a large-power isolator between an output end of the amplifier circuit of the MRI apparatus and the RF coil, variations in transmission efficiency of the amplifier circuit can be suppressed. Further, since the isolator becomes unnecessary, downsizing of the amplifier apparatus and significant cost reduction become possible.

### (First Modification of First Embodiment)

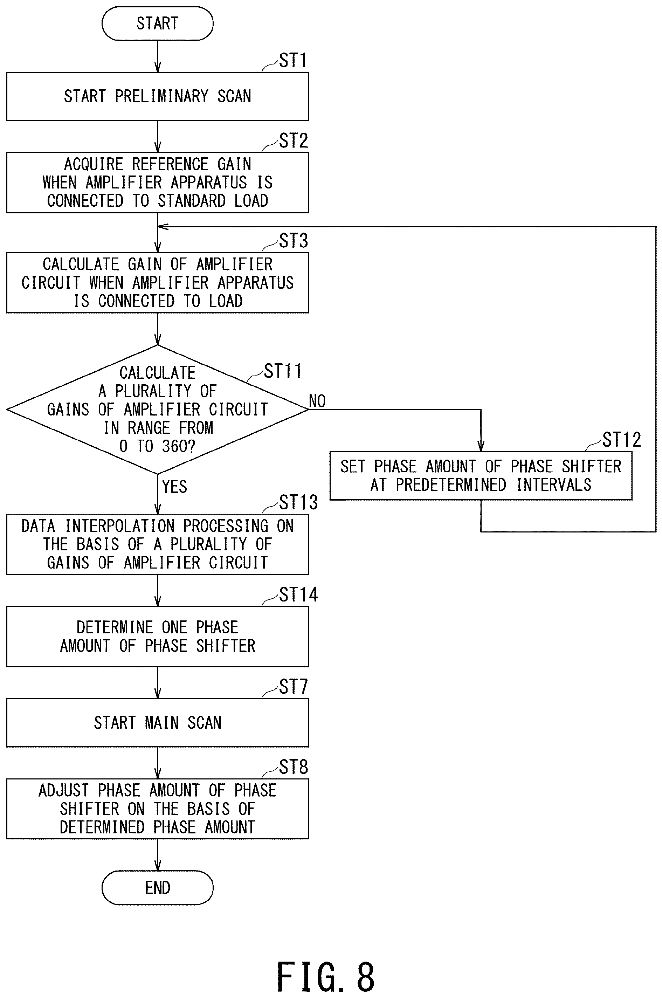

Fig. 8 is a flowchart illustrating an operation example of an amplifier apparatus according to a first modification of the first embodiment. In the first modification of the first embodiment, it is different from the first embodiment in that a plurality of gains of the amplifier circuit 362 when the amplifier apparatus 35 is connected to the load 60 are calculated at discrete intervals in a range from 0° to 360° (for example, a range of phase angles for 360° from -180° to +180°), and one phase amount is determined from among a plurality of phase amounts of the phase shifter 366 which are within the predetermined range with respect to the reference gain. In the first modification of the first embodiment, after step ST3, the process proceeds to step ST11.

In step ST11, the switching control circuit 365 determines whether a plurality of gains of the amplifier circuit 362 when the amplifier apparatus 35 is connected to the load 60 have been calculated for a plurality of phase amounts of the phase shifter 366 set at discrete intervals in a range from 0° to 360°. In step ST11, when the plurality of gains of the amplifier circuit 362 have not been calculated (that is, NO), the process proceeds to step ST12.

In step ST12, the switching control circuit 365 sets a plurality of phase amounts of the phase shifter 366 at discrete intervals, for example, at predetermined intervals, in a range from 0° to 360°, and adjusts the phase amount of the phase shifter 366 as set. Here, the predetermined interval may be, for example, increments of 45° or increments of 30°, and can be set from the viewpoint of a speed of data interpolation processing and an accuracy of the data interpolation in step ST13. After the phase amount of the phase shifter 366 is adjusted in step ST12, the process proceeds to step ST3, and the switching control circuit 365 calculates gain of the amplifier circuit 362 at the phase amount.

In step ST11, when gains of the amplifier circuit 362 in the range from 0° to 360° have been calculated (that is, YES), the process proceeds to step ST13. In step ST13, the switching control circuit 365 performs the data interpolation processing on the basis of a plurality of gains of the amplifier circuit 362 calculated at the predetermined intervals.

In step ST14, when there are a plurality of phase amounts of the phase shifter 366 corresponding to gain falling within the predetermined range with respect to the reference gain, the switching control circuit 365 determines one phase amount from among the plurality of phase amounts on the basis of data subjected to the interpolation processing. In the first modification of the first embodiment, after step ST14, the process proceeds to step ST7. Then, in step ST8, a phase amount of the phase shifter 366 is adjusted on the basis of the one phase amount determined in step ST14.

Fig. 7 represents a situation in which, when the data interpolation processing is performed after a plurality of gains of the amplifier circuit 362 are calculated in 45° increments in a range of phase angles for 360° from -180° to +180°, gain corresponding to a phase angle P1 around 45° and gain corresponding to a phase angle P2 around -135° match the reference gain at the time of the standard load. That is, in the first modification of the first embodiment, by performing the data interpolation processing, it is possible to obtain gain even closer to the reference gain at the time of the standard load than in the first embodiment.

### (Second Modification of First Embodiment)

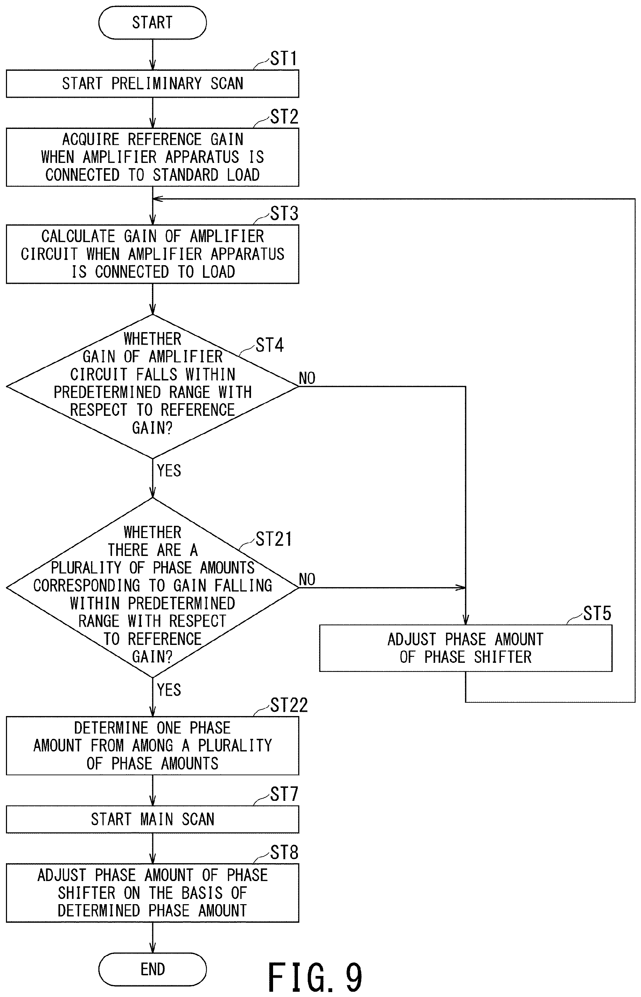

Fig. 9 is a flowchart illustrating an operation example of an amplifier apparatus according to a second modification of the first embodiment. In the second modification of the first embodiment, it is different from the first embodiment in that, from among a plurality of phase amounts of the phase shifter 366 where a plurality of gains of the amplifier circuit 362 when the amplifier apparatus 35 is connected to the load 60 are within the predetermined range with respect to the reference gain, one phase amount is determined. In the second modification of the first embodiment, when YES at step ST4, the process proceeds to step ST21.

In step ST21, the switching control circuit 365 determines whether there are a plurality of phase amounts corresponding to gain falling within the predetermined range with respect to the reference gain. In step ST21, when there are not a plurality of phase amounts corresponding to gain falling within the predetermined range (that is, NO), the process proceeds to step ST5. In step ST21, when there are a plurality of phase amounts corresponding to gain falling within the predetermined range (that is, YES), the switching control circuit 365 ends calculation of gain of the amplifier circuit 362, and the process proceeds to step ST22.

In step ST22, the switching control circuit 365 determines one phase amount from among the plurality of phase amounts. In the second modification of the first embodiment, after step ST22, the process proceeds to step ST7. Then, in step ST8, a phase amount of the phase shifter 366 is adjusted on the basis of the one phase amount determined in step ST22.

As shown in step ST14 in Fig. 8 and step ST22 in Fig. 9, in the preliminary scan, the phase control circuit calculates gain of the amplifier circuit 362 corresponding to each of a plurality of phases as phases of a signal amplified by the amplifier circuit 362, and may determine, on the basis of the gain of the amplifier circuit 362 corresponding to each of the plurality of phases, a phase to be used in the main scan.

In the first modification of the first embodiment, a plurality of gains of the amplifier circuit 362 are calculated at discrete intervals in a range from 0° to 360°, and data is collected by the interpolation processing. In contrast, in the second modification of the first embodiment, it is not necessary to complete data collection in the range from 0° to 360°, and, the data collection and the interpolation processing may be stopped at the time when a plurality of phase amounts (for example, two phase amounts) corresponding to gain falling within the predetermined range with respect to the reference gain exist, and the process may proceed to processing of determining one phase amount in step ST22.

### (Second Embodiment)

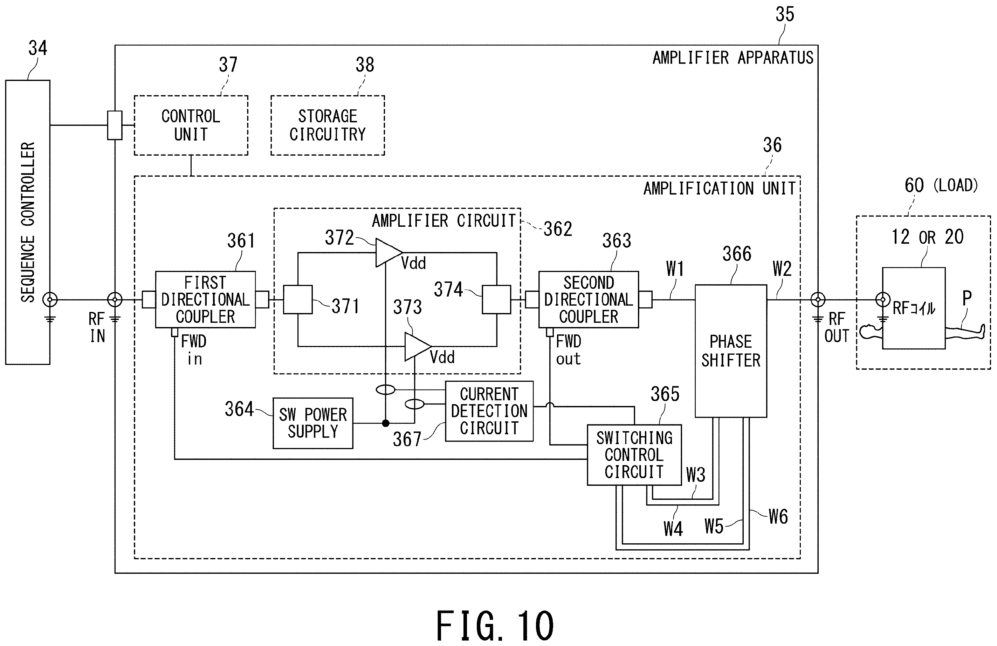

Fig. 10 is a block diagram illustrating a configuration example of an amplifier apparatus according to a second embodiment. The second embodiment is different from the first embodiment in that the amplification unit 36 further includes a current detection circuit 367.

The current detection circuit 367 detects current supplied to the amplifier circuit 362. The current detection circuit 367 may detect drain current of the amplification elements 372 and 373, or may detect consumption current of the amplifier circuit 362.

In the second embodiment, the switching control circuit 365 adjusts a phase amount of the phase shifter 366 on the basis of current detected by the current detection circuit 367. That is, in the second embodiment, the phase shifter 366 is adjusted by determining one phase amount such that a plurality of gains of the amplifier circuit 362 when the amplifier apparatus 35 is connected to the load 60 fall within the predetermined range with respect to the reference gain and current supplied to the amplifier circuit 362 becomes smallest.

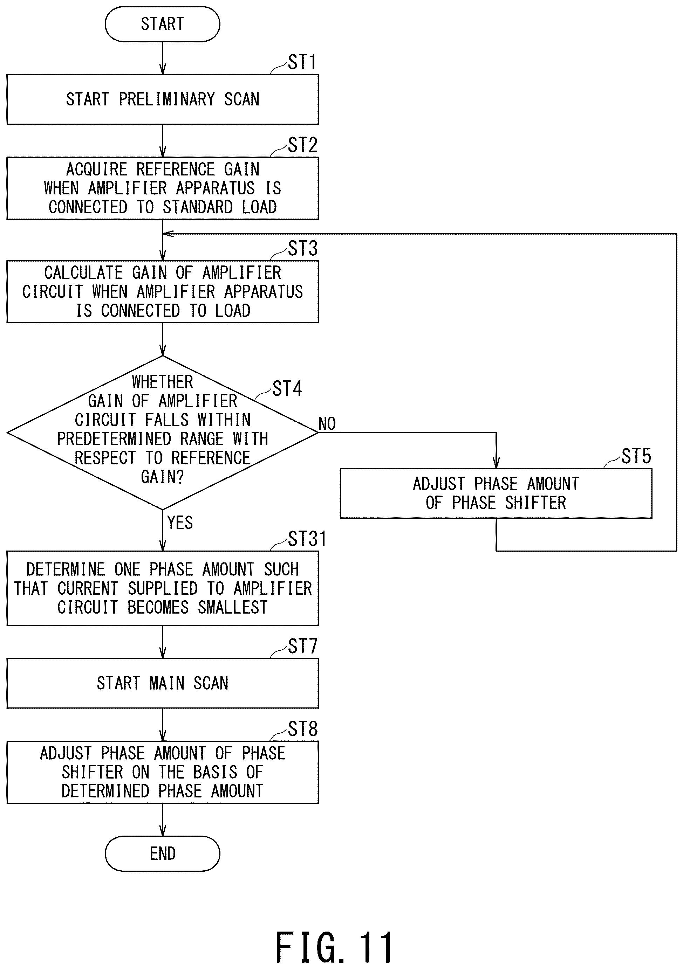

Fig. 11 is a flowchart illustrating an operation example of the amplifier apparatus according to the second embodiment. In the second embodiment, when YES at step ST4, the process proceeds to step ST31.

In step ST31, the switching control circuit 365 determines, from among a plurality of phase amounts corresponding to gain of the amplifier circuit 362 when the amplifier apparatus 35 is connected to the load 60 that falls within a predetermined range with respect to a reference gain when the amplifier apparatus 35 is connected to the standard load, one phase amount such that current supplied to the amplifier circuit 362 becomes smallest. After step ST31, the process proceeds to step ST7.

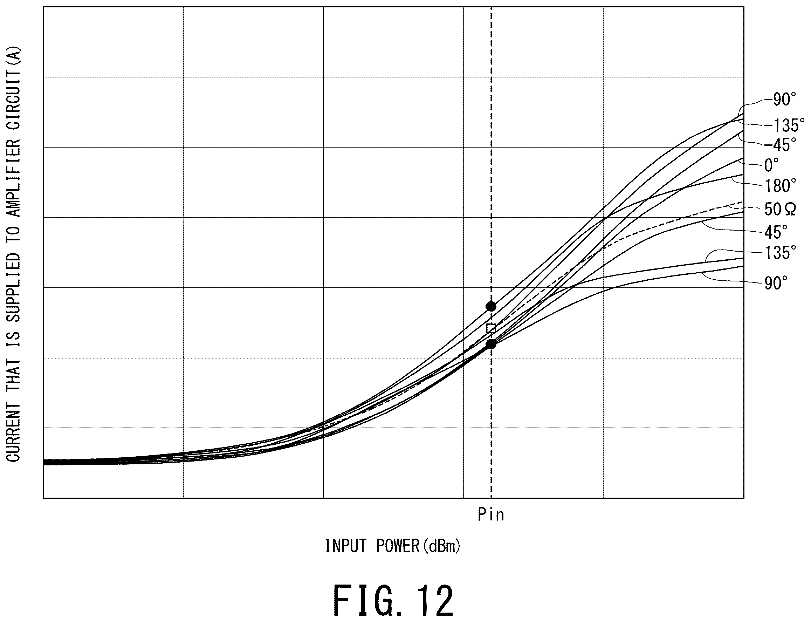

Here, Fig. 12 is a graph illustrating a relationship between input power and current supplied to the amplifier circuit 362 at the time of the load mismatch. Fig. 12 represents a 50 Ω standard load and a state in which a VSWR has phase angles for 360° in 45° increments from -180° to +180°. In this way, when the load mismatch occurs in the amplifier circuit 362, current supplied to the amplifier circuit 362 changes even when the same power is inputted.

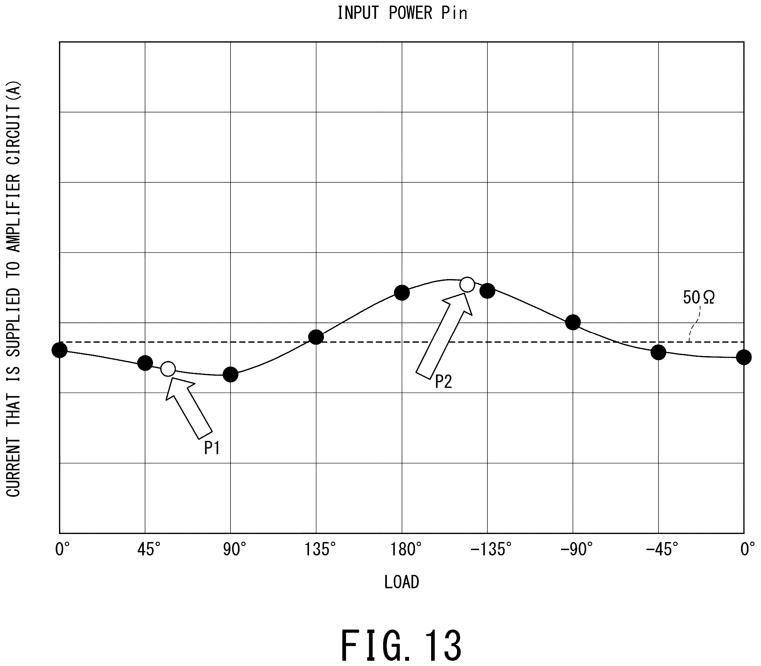

Fig. 13 is a graph illustrating a relationship between a phase angle for 360° at the particular input power Pin and current supplied to the amplifier circuit 362. As shown in Fig. 7, gain corresponding to the phase angle P1 around 45° and gain corresponding to the phase angle P2 around -135° are close to the reference gain at the time of the standard load. In Fig. 13 as well, a plurality (two locations) of the phase angles P1 and P2 such that the same gain as at the time of the standard load is obtained, are represented similarly to Fig. 7.

In Fig. 13, of the phase angle P1 around 45° and the phase angle P2 around -135°, it is represented that current supplied to the amplifier circuit 362 at the phase angle P1 around 45° is smaller than current supplied to the amplifier circuit 362 at the phase angle P2 around -135°. In the amplifier apparatus 35 according to the second embodiment, the phase shifter 366 is adjusted with one phase amount corresponding to a phase angle such that gain of the amplifier circuit 362 falls within the predetermined range with respect to the reference gain and current supplied to the amplifier circuit 362 becomes smallest. Therefore, with the amplifier apparatus according to the second embodiment, while obtaining the same effects as in the first embodiment, it is also possible to suppress heat generation and consumption current of the amplifier circuit.

According to at least one embodiment described above, it is possible to suppress variations in transmission efficiency of the amplifier circuit of the MRI apparatus without providing a large-power isolator between an output end of the amplifier circuit and the RF coil.

In the above embodiments, the term "processor" means, for example, circuitry such as a dedicated or general-purpose central processing unit (CPU), a graphics processing unit (GPU), an application specific integrated circuit (ASIC), or a programmable logic device (for example, a simple programmable logic device (SPLD), a complex programmable logic device (CPLD), or a field programmable gate array (FPGA)).

When the processor is, for example, a CPU, the processor reads and executes a program stored in storage circuitry to implement various functions. When the processor is, for example, an ASIC, a function corresponding to the program is directly incorporated as logic circuitry in circuitry of the processor instead of the processor storing the program in the storage circuit. In this case, the processor implements various functions by hardware processing of reading and executing the program incorporated in the circuitry, or the processor can also implement various functions by combining software processing and hardware processing.

In the embodiments described above, the example is described in which the single processor of the processing circuitry implements the functions. However, the processing circuitry may be configured by combining a plurality of independent processors, and the processors may implement the respective functions. In a case where the plurality of processors is provided, the storage circuitry that stores the programs may be provided individually for each processor, or one piece of storage circuitry may collectively store the programs corresponding to the functions of all the processors.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims are intended to cover such forms or modifications as would fall within the scope and spirit of the inventions.

## Claims

1. A magnetic resonance imaging apparatus comprising:
a static magnetic field magnet configured to generate a static magnetic field in a bore;
an amplifier circuit configured to amplify an input signal;
a phase control circuit configured to control a phase of a signal amplified by the amplifier circuit on a basis of gain of the amplifier circuit obtained from a signal inputted to the amplifier circuit and a signal amplified by the amplifier circuit, and on a basis of a reference gain; and
an RF coil configured to transmit, to a subject placed in the bore, an RF pulse based on a signal amplified by the amplifier circuit and whose phase is controlled by the phase control circuit.

2. The magnetic resonance imaging apparatus according to claim 1, wherein
the phase control circuit is configured to
determine, on a basis of gain of the amplifier circuit obtained from a signal inputted to the amplifier circuit in a preliminary scan executed before a main scan for obtaining a diagnostic image of the subject and a signal amplified by the amplifier circuit in the preliminary scan, and on the basis of the reference gain, a phase to be used in the main scan, and
control, on a basis of a phase determined by the preliminary scan, a phase of a signal amplified by the amplifier circuit in the main scan.

3. The magnetic resonance imaging apparatus according to claim 2, wherein
the phase control circuit is configured to determine, as a phase to be used in the main scan, a phase such that a difference between gain of the amplifier circuit obtained in the preliminary scan and the reference gain becomes the same as or smaller than a predetermined amount.

4. The magnetic resonance imaging apparatus according to claim 3, wherein
the phase control circuit is configured to
control, when the difference is greater than the predetermined amount in the preliminary scan, from a first phase which is a phase of the signal amplified by the amplifier circuit to a second phase different from the first phase, and
determine, when the difference is the same as or smaller than the predetermined amount in the preliminary scan, the phase of the signal amplified by the amplifier circuit is the second phase,
wherein the second phase is as a phase to be used in the main scan.

5. The magnetic resonance imaging apparatus according to claim 3, wherein
the phase control circuit is configured to
calculate, in the preliminary scan, gain of the amplifier circuit corresponding to each of a plurality of phases as phases of a signal amplified by the amplifier circuit, and
determine, on a basis of gain of the amplifier circuit corresponding to each of the plurality of phases, a phase to be used in the main scan.

6. The magnetic resonance imaging apparatus according to claim 5, further comprising
a current detection circuit configured to detect current supplied to the amplifier circuit, wherein
the phase control circuit is configured to determine, when there are a plurality of phases corresponding to gain such that the difference becomes smaller than the predetermined amount, from among the plurality of phases, one phase such that the current becomes smallest, as a phase to be used in the main scan.

7. The magnetic resonance imaging apparatus according to any one of claim 1 to claim 6, wherein
the phase control circuit is configured to have a capacitor and adjust a phase of a signal amplified by the amplifier circuit by changing a capacitance of the capacitor.

8. An amplifier apparatus connected to an RF coil that transmits an RF pulse to a subject to be imaged by a magnetic resonance imaging apparatus, the amplifier apparatus comprising:
an amplifier circuit configured to amplify an input signal;
a phase control circuit configured to control a phase of a signal amplified by the amplifier circuit on a basis of gain of the amplifier circuit obtained from a signal inputted to the amplifier circuit and a signal amplified by the amplifier circuit, and on a basis of a reference gain; and
an output part configured to output, to the RF coil, a signal amplified by the amplifier circuit and whose phase is adjusted by the phase control circuit.

9. The amplifier apparatus according to claim 8, wherein
the phase control circuit is configured to
determine, on a basis of gain of the amplifier circuit obtained from a signal inputted to the amplifier circuit in a preliminary scan executed before a main scan for obtaining a diagnostic image of the subject and a signal amplified by the amplifier circuit in the preliminary scan, and on the basis of the reference gain, a phase to be used in the main scan, and
control, on a basis of a phase determined by the preliminary scan, a phase of a signal amplified by the amplifier circuit in the main scan.

10. The amplifier apparatus according to claim 9, wherein
the phase control circuit is configured to determine, as a phase to be used in the main scan, a phase such that a difference between gain of the amplifier circuit obtained in the preliminary scan and the reference gain becomes the same as or smaller than a predetermined amount.

11. The amplifier apparatus according to claim 10, wherein
the phase control circuit is configured to
control, when the difference is greater than the predetermined amount in the preliminary scan, from a first phase which is a phase of the signal amplified by the amplifier circuit to a second phase different from the first phase, and
determine, when the difference is the same as or smaller than the predetermined amount in the preliminary scan, the phase of the signal amplified by the amplifier circuit is the second phase,
wherein the second phase is as a phase to be used in the main scan.

12. The amplifier apparatus according to claim 10, wherein
the phase control circuit is configured to
calculate, in the preliminary scan, gain of the amplifier circuit corresponding to each of a plurality of phases as phases of a signal amplified by the amplifier circuit, and
determine, on a basis of gain of the amplifier circuit corresponding to each of the plurality of phases, a phase to be used in the main scan.

13. The amplifier apparatus according to claim 12, further comprising
a current detection circuit configured to detect current supplied to the amplifier circuit, wherein
the phase control circuit is configured to determine, when there are a plurality of phases corresponding to gain such that the difference becomes smaller than the predetermined amount, from among the plurality of phases, one phase such that the current becomes smallest, as a phase to be used in the main scan.

14. The amplifier apparatus according to any one of claim 8 to claim 13, wherein
the phase control circuit is configured to have a capacitor and adjust a phase of a signal amplified by the amplifier circuit by changing a capacitance of the capacitor.
